# EUROPEAN PATENT APPLICATION

(11) **EP 1 561 841 A2**
(43) Date of publication of application: **10.08.2005**
(21) Application number: 05000894.5
(22) Date of filing: 18.01.2005
(51) Int. Cl.: C23C 16/44

(54) **Cleaning CVD Chambers following deposition of porogen-containing materials**

(30) Priority: 23.01.2004 US 538832 P; 22.12.2004 US 19709
(71) Applicant: AIR PRODUCTS AND CHEMICALS, INC., Allentown, PA 18195-1501 (US)
(72) Inventor: Johnson, Andrew David, Doylestown PA 18901 (US); Dheandhanoo, Seksan, Quakertown PA 18951 (US); Bitner, Mark Daniel, Nazareth PA 18064 (IS); Vrtis, Raymond Nicholas, Orefield PA 18069 (US)
(74) Representative: Teipel, Susanne, Dr.

(57) **Abstract**

The present invention is a process for cleaning equipment surfaces in a semiconductor material processing chamber after deposition of a porous film containing a porogen, comprising;
contacting the equipment surfaces with a proton donor containing atmosphere to react with the porogen deposited on the equipment surfaces;
contacting the equipment surfaces with a fluorine donor containing atmosphere to react with the film deposited on the equipment surfaces.

## Description

### CROSS REFERENCE TO RELATED APPLICATION

The present application is a continuation-in-part of US Provisional Application S.N. 60/538,832 filed 23 January 2004.

### BACKGROUND OF THE INVENTION

Periodically, chemical vapor deposition ("CVD") chambers need cleaning to prevent particle contamination. They are typically cleaned using a plasma etch process (e.g., C₂F₆/O₂) that volatizes the CVD residue (e.g., tetraethylorthosilcate, TEOS). Current chamber clean processes are ineffective at removing residue following CVD of porous dielectric materials, however.

While the CVD deposition process desirably forms thin films on a substrate (typically a silicon wafer), the reactions that form these films also occurs non-productively on exposed surfaces inside of the process chamber leaving a large amount of residues on the chamber walls, the showerhead, and the foreline downstream of the process chamber. These residues typically contain carbon, i.e., carbon-containing residues. Additional species that may also be present in the carbon-containing residues include, for example, silicon from the precursor mixture and/or fluorine from exposure to fluorinated gas-based plasmas used for cleaning and/or fluorine-containing precursors. Accumulation of the carbon-containing residues inside the chamber may result in particle shedding, degradation of deposition uniformity, and processing drifts that can affect subsequent depositions. These effects can lead to defects in the deposited structures and device failure. Therefore, periodic cleaning of the process chamber, also referred to as chamber cleaning, is necessary. These residues have to be removed in order to ensure the integrity (uniformity, composition purity, reproducibility) of the composite organosilicate films subsequently deposited. In some cases this carbon-containing residue may be present in the form of oligomers and polymers thus making residue removal more challenging.

In the article "Reducing PFC Emissions from CVD Chamber Cleaning," Solid State Technology, p. 103 (December 2000), CVD chambers are typically cleaned using fluorocarbon plasmas (e.g., C₂F₆). A C₂F₆/O₂ plasma is a generally practiced method throughout the semiconductor industry for cleaning CVD chambers. Oxygen (O₂ or N₂O) additions are necessary to prevent polymer formation in a fluorine deficient discharge. The role of oxygen in these processes is to convert the carbon atoms of the fluorocarbon (e.g., C₂F₆) into CO₂.

In US 5,413,670 and US 6,067,999, residues of SiNₓ and SiO₂ are removed from the walls of a CVD chamber using a plasma generated from NF₃ and other diluents (e.g., He, Ar, N₂). Fluorine atoms generated in the NF₃ plasma react with the CVD residue forming volatile byproducts. Processes having high etch rates are disclosed (NF₃ concentration, pressure, radio frequency ("RF") power, flow rates).

US 6,569,257 B1 teaches a method of cleaning a process chamber following CVD of silicon carbide (SiC) and organosilica glass (OSG). The SiC and OSG material is removed through a combination of hydrogen and fluorine plasmas (e.g., H₂ and NF₃). US 6,569,257 is specifically directed to removing SiC and OSG residues. The role of the hydrogen plasma in US 6,569,257 is to break silicon-carbon bonds, that are an inherent component of the SiC and OSG structure. SiC and OSG materials can successfully be cleaned using an NF₃/O₂ plasma. Inclusion of a hydrogen plasma simply increases the etch rate.

US 5,326,723A discloses a method of cleaning a process chamber following tungsten CVD. The CVD chamber is cleaned with an NF₃ plasma followed by a H₂ plasma. US 5,326,723A is specifically directed to removing tungsten residues. The tungsten is volatized as WF₆ by the NF₃ plasma. The purpose of the subsequent H₂ plasma is to scavenge fluorine byproducts of the NF₃-based chamber clean.

US 5,129,958 describes a H₂ plasma used to remove fluorine byproducts produced during a preceding chamber clean. Following a generally practiced method of cleaning CVD chambers (e.g., NF₃ plasma), residual amounts of fluorine remain in the CVD chamber. US 5,326,958 provides a method of removing these fluorine residues through reaction with a reducing gas (e.g., H₂). The purpose of the subsequent H₂ plasma is to scavenge fluorine byproducts of the NF₃-based chamber clean.

US 6,534,423 teaches that a H₂ plasma is used to remove fluorine byproducts produced during a preceding chamber clean. Following a generally practiced method of cleaning CVD chambers (e.g., NF₃ plasma), residual fluorine is impregnated in the walls of the CVD chamber, limiting adhesion of the CVD film. US 6,534,423 provides a method of removing these fluorine residues through reaction with a reducing gas (e.g., H₂). The purpose of the subsequent H₂ plasma is to scavenge fluorine byproducts of the NF₃-based chamber clean.

US 6,626,188 B2 discloses that a hydrogen plasma is used to condition the dome of a CVD chamber. The purpose of this invention is to passivate the surfaces of the CVD chamber. Materials of construction for a CVD chamber include Al₂O₃. During any fluorine-based (e.g., NF₃) chamber clean, the chamber walls may be fluorinated. US 6,534,188 shows how the resulting AIF₃ may be removed using a hydrogen plasma.

US 2003/0183244 A1 describes an invention that is a replacement to the traditional wet clean, that is performed after a CVD chamber has processed many (e.g., 5000 wafers). No CVD residue is removed from the chamber. After deposition, the CVD chamber must still be cleaned periodically (e.g., after 1 to 5 wafers) using a generally accepted method (e.g., NF₃ plasma). After a large number of deposition and clean cycles (e.g., 5000), however, the CVD chamber must be disassembled and its components cleaned using aqueous acids and solvents (e.g., HF and isopropyl alcohol ("IPA")). US 2003/0183244 proposes a dry etch process to replace this wet cleaning.

US 5,135,775 discloses a H₂ plasma used to clean a substrate prior to depositing a thin film by physical vapor deposition ("PVD") or plasma enhanced CVD ("PECVD"). US 5,135,775 is directed towards preparing a substrate (e.g., silicon wafer) rather than cleaning the process chamber of CVD residues.

WO 2002/007203 teaches that during plasma etching, i.e. reactive ion etching ("RIE"), polymer residue is deposited on the silicon substrate. WO 2002/007203 uses H₂/N₂ or NH₃/N₂ mixtures to facilitate removal of this etch residue. This invention is directed towards wafer cleaning following plasma etch, rather than cleaning process chambers following CVD.

JP 2001/102311 describes a plasma comprising of hydrogen (e.g., H₂) and halogen (e.g., F₂) gases is used to clean polysilicon wafers before forming a gate insulator. Presumably, the H₂ and F₂ components generate HF that removes any native oxide. JP 2001/102311 relates to wafer cleaning rather than cleaning CVD chambers with a plasma etch process.

The prior art has not addressed removal of porogen from CVD chamber walls after porous dielectric depositions. The typically large unsaturated hydrocarbons which are used as porogens present unique problems of chamber cleaning not considered or addressed by the prior art, yet constituting a significant problem for inclusion of porous dielectric into integrated circuit manufacturing. The present invention overcomes this problem in the industry as will be illustrated below, in contrast to the deficiencies of the prior art.

### BRIEF SUMMARY OF THE INVENTION

The present invention is a process for cleaning equipment surfaces in a semiconductor material processing chamber after deposition of a porous film containing a porogen, comprising;
contacting the equipment surfaces with a proton donor containing atmosphere to react with the porogen deposited on the equipment surfaces;
contacting the equipment surfaces with a fluorine donor containing atmosphere to react with the film deposited on the equipment surfaces.

Preferably, the process includes contacting the equipment surfaces with an oxygen donor containing atmosphere to react with the film deposited on the equipment surfaces when contacting with a fluorine donor, particularly when the fluorine donor does not contain oxygen.

More preferably, the present invention is a process for cleaning equipment surfaces in a semiconductor material CVD processing chamber after deposition of a porous dielectric film containing a porogen, comprising;
evacuating a zone contacting the equipment surface;
maintaining the zone under plasma conditions;
contacting the equipment surfaces with a proton donor containing atmosphere to react with the porogen deposited on the equipment surfaces;
evacuating the zone contacting the equipment surface;
contacting the equipment surfaces with a fluorine donor and oxygen source containing atmosphere to react with the dielectric film deposited on the equipment surfaces to clean the equipment surfaces.

### BRIEF DESCRIPTION OF SEVERAL VIEWS OF THE DRAWINGS

Figure 1 is a quadrupole mass spectrometer ("QMS") profile of volatilized effluents during a C₂F₆ chamber clean of a porogen containing film deposition of the prior art.

Figure 2 is a QMS profile of volatilized effluents during an NF₃ chamber clean of a porogen containing film deposition of the present invention including a proton donor agent.

### DETAILED DESCRIPTION OF THE INVENTION

Semiconductor devices are fabricated by the sequential deposition, and patterning, of thin film materials (e.g., silicon dioxide) on a silicon wafer. During chemical vapor deposition (CVD) of thin films, material is deposited on the surfaces of the process chamber, as well as the silicon wafer. Periodically, CVD chambers need to be cleaned to prevent particle contamination. The process chamber is cleaned using a plasma etch process that volatilizes the CVD residues on the chamber walls.

The interlayer dielectric (ILD) film of semiconductor devices has historically been a silicon oxide material (e.g., TEOS). These silicon-based materials (e.g., SiO₂) can be volatized through reaction with fluorine. Fluorine atoms, generated in a glow discharge, react with silicon to for SiF₄ gas that is evacuated from the CVD chamber.

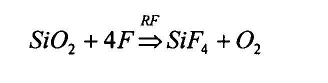

Perfluorocompounds (PFCs, e.g. CF₄, C₂F₆, NF₃) as well as fluorine gas (F₂) are a convenient source of fluorine atoms or radicals (F) in CVD chamber clean processes. PFCs are easy to handle, since they are non-corrosive and are unreactive with materials of construction or atmospheric gases under ambient conditions, prior to their decomposition. CVD chambers are typically cleaned using a C₂F₆/O₂ or NF₃-based plasma etch process.

The interlayer dielectric film is typically a silicon oxide containing film prepared using a precursor such as; tetraethylorthosilcate, triethylmethylorthosilcate, diethoxymethylsilane, methylsilane, trimethylsilane dimethylethylsilane or their corresponding siloxanes, or silane, and their respective homologs and analogs, tetramethoxysilane, tetra-n-propoxysilane, tetraisopropoxysilane tetra-n-butoxysilane, tetra-sec-butoxysilane, tetra- tert-butoxysilane, tetraacetoxysilane, and tetraphenoxysilane, hexamethoxydisiloxane, hexaethoxydisiloxane, hexaphenoxydisiloxane, 1,1,1,3,3-pentamethoxy-3- methyldisiloxane, 1,1,1,3,3-pentaethoxy-3-methyldisiloxane, 1,1,1,3,3-pentamethoxy-3-phenyldisiloxane, 1,1,1,3,3-pentaethoxy-3-phenyldisiloxane, 1, 1,3,3-tetramethoxy-1 ,3-dimethyldisiloxane, 1,1,3,3-tetraethoxy-1,3-dimethyldisiloxane, 1,1,3,3-tetramethoxy-1,3-diphenyldisiloxane, 1,1,3,3-tetraethoxy-1,3-diphenyldisiloxane, 1,1,3-trimethoxy-1,3,3-trimethyldisiloxane, 1,1,3-triethoxy-1,3,3-trimethyldisiloxane, 1,1,3-trimethoxy-1,3,3-triphenyldisiloxane, 1,1,3-triethoxy-1,3,3-triphenyldisiloxane, 1,3-dimethoxy-1 ,1,3,3-tetramethyldisiloxane, 1,3-diethoxy-1,1,3,3-tetramethyldisiloxane, 1,3-dimethoxy-1, 1,3,3-tetraphenyldisiloxane and 1,3-diethoxy-1,1,3,3-tetraphenyldisiloxane. Of those, preferred compounds are hexamethoxydisiloxane, hexaethoxydisiloxane, hexaphenoxydisiloxane, 1,1,3,3-tetramethoxy-1,3-dimethyldisiloxane, 1,1,3,3-tetraethoxy-1 ,3-dimethyldisiloxane, 1,1,3,3-tetramethoxy-1,3-diphenyldisiloxane, 1,3-dimethoxy-1,1,3,3-tetramethy)disi)oxane, 1,3-diethoxy-1,1,3,3-tetramethyldisiloxane, 1,3-dimethoxy-1,1,3,3-tetraphenyldisiloxane;1,3-diethoxy-1,1,3,3-tetraphenyldisiloxane. Specific examples of these compounds wherein R⁷ is a group represented by -(CH₂)ₙ- include: bis(trimethoxysilyl)methane, bis(triethoxysilyl)methane, bis(triphenoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane, bis(ethoxydiphenylsilyl)methane, 1,2-bis(trimethoxysilyl)ethane, 1,2-bis(triethoxysilyl)ethane, 1,2-bis(triphenoxysilyl)ethane, 1,2-bis(dimethoxymethylsilyl)ethane, 1,2-bis(diethoxymethylsilyl)ethane, 1,2-bis(dimethoxyphenylsilyl)ethane, 1,2-bis(diethoxyphenylsilyl)ethane, 1,2-bis(methoxydimethylsilyl)ethane, 1,2-bis(ethoxydimethylsilyl)ethane, 1,2-bis(methoxydiphenylsilyl)ethane, 1,2-bis(ethoxydiphenylsilyl)ethane, 1,3-bis(trimethoxysilyl)propane, 1,3-bis(triethoxysilyl)propane, 1,3-bis(triphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimethylsilyl)propane, 1,3-bis(ethoxydimethylsilyl)propane, 1,3-bis(methoxydiphenylsilyl)propane; 1,3-bis(ethoxydiphenylsilyl) propane;. Of those, preferred compounds are bis(trimethoxysilyl)methane, bis(triethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane and bis(ethoxydiphenylsilyl)methane, tetraacetoxysilane, methyltriacetoxysilane, ethyltriacetoxysilane, n-propyltriacetoxysilane, isopropyltriacetoxysilane, n-butyltriacetoxysilane, sec-butyltriacetoxysilane, tert-butyltriacetoxysilane, isobutyltriacetoxysilane, n-pentyltriacetoxysilane, sec-pentyltriacetoxysilane, tert-pentyltriacetoxysilane, isopentyltriacetoxysilane, neopentyltriacetoxysilane, phenyltriacetoxysilane, dimethyldiacetoxysilane, diethyldiacetoxysilane, di-n-propyldiacetoxysilane, diisopropyldiacetoxysilane, di-n-butyldiacetoxysilane, di-sec-butyldiacetoxysilane, di-tert-butyldiacetoxysilane, diphenyldiacetoxysilane, triacetoxysilane, hydrogen silsesquioxanes (HSQ, HSiO_{1.5}) and methyl silsesquioxanes (MSQ, RSiO_{1.5} where R is a methyl group) and tetramethylcyclotetrasiloxane.

Preferably, the porous film is selected from the group consisting of diethoxymethylsilane, dimethoxymethylsilane, di-isopropoxymethylsilane, di-t-butoxymethylsilane, methyltriethoxysilane, methyltrimethoxysilane, methyltriisopropoxysilane, methyltri-t-butoxysilane, dimethyldimethoxysilane, dimethyldiethoxysilane, dimethyldi-isopropoxysilane, dimethyldi-t-butoxysilane, 1,3,5,7-tetramethylcyclotatrasiloxane, octamethyl-cyclotetrasiloxane, tetraethoxysilane, and mixtures thereof.

The ILD film may also be an OSG with the composition represented by the formula SiᵥO_{w}CₓHyF_{z}, where v+w+x+y+z = 100%, v is from 5 to 35 atomic%, w is from 10 to 65 atomic%, x is from 5 to 70 atomic%, y is from 10 to 70 atomic%, and z is from 0 to 15 atomic%.

Fabrication of advanced semiconductors requires an ILD having a lower dielectric constant than that of silicon oxide (4.0). The dielectric constant of interlayer dielectric (ILD) materials can be reduced by incorporating porosity. ILDs are made porous by introducing a porogen (e.g., terpenes) during chemical vapor deposition (CVD). The porogen is subsequently removed from the deposited ILD film in a post-CVD treatment (e.g., heat or UV exposure) that introduces voids where the porogen had been, reducing the material density, and dielectric constant. Carbon-doped silicon dioxide (CDO) deposited using diethoxymethylsilane ("DEMS"), typically has a dielectric constant of 3.0. By introducing terpenes during CVD, the dielectric constant can be reduced to 2.2 to 2.5. A "porogen", as used herein, is a reagent that is used to generate void volume within the resultant film. Broadly the porogen can be at least one member selected from the group represented by: (a) at least one cyclic hydrocarbon having a cyclic structure and the formula CₙH₂ₙ, where n is 4 to 14, a number of carbons in the cyclic structure is between 4 and 10, and the at least one cyclic hydrocarbon optionally contains a plurality of simple or branched hydrocarbons substituted onto the cyclic structure; (b) at least one linear or branched, saturated, partially or fully unsaturated hydrocarbon having the formula CₙH(₂ₙ₊₂)_{-2y} where n = 2 - 20 and where y = 0 - n; (c) at least one singly or multiply unsaturated cyclic hydrocarbon having a cyclic structure and the formula CₙH₂ₙ₋₂ₓ, where x is a number of unsaturated sites, n is 4 to 14, a number of carbons in the cyclic structure is between 4 and 10, and the at least one singly or multiply unsaturated cyclic hydrocarbon optionally contains a plurality of simple or branched hydrocarbons substituents substituted onto the cyclic structure, and contains unsaturation inside endocyclic or on one of the hydrocarbon substituents; (d) at least one bicyclic hydrocarbon having a bicyclic structure and the formula CₙH₂ₙ₋₂, where n is 4 to 14, a number of carbons in the bicyclic structure is from 4 to 12, and the at least one bicyclic hydrocarbon optionally contains a plurality of simple or branched hydrocarbons substituted onto the bicyclic structure; (e) at least one multiply unsaturated bicyclic hydrocarbon having a bicyclic structure and the formula CₙH₂ₙ₋₍₂₊₂ₓ₎, where x is a number of unsaturated sites, n is 4 to 14, a number of carbons in the bicyclic structure is from 4 to 12, and the at least one multiply unsaturated bicyclic hydrocarbon optionally contains a plurality of simple or branched hydrocarbons substituents substituted onto the bicyclic structure, and contains unsaturation inside endocyclic or on one of the hydrocarbon substituents; (f) at least one tricyclic hydrocarbon having a tricyclic structure and the formula (a) CₙH₂ₙ₋₄, where n is 4 to 14, a number of carbons in the tricyclic structure is from 4 to 12, and the at least one tricyclic hydrocarbon optionally contains a plurality of simple or branched hydrocarbons substituted onto the cyclic structure; and mixtures thereof.

More specifically, suitable porogens for use in the dielectric materials of the present invention include labile organic groups, solvents, decomposable polymers, surfactants, dendrimers, hyper-branched polymers, polyoxyalkylene compounds, organic macromolecules, or combinations thereof. Typical porogens include; alpha-terpinene, limonene, cyclohexane, 1,2,4-trimethylcyclohexane, 1,5-dimethyl-1,5-cyclooctadiene, camphene, adamantane, 1,3-butadiene, substituted Cₓ dienes where x = 2-18 and decahydronaphthelene.

In addition, porous dielectric films can be produced using molecules containing porogen functionality bonded to the silica precursors, such as; porogenated 1,3,5,7-tetramethylcyclo-tetrasiloxanes, such as di-neohexyl-diethoxysilane, 1,4-bis(diethoxysilyl)cyclohexane, trimethylsilylethyl-1,3,5,7-tetramethylcyclo-tetrasiloxane, 1-neohexyl-1,3,5,7-tetramethylcyclotetrasiloxane, 1-neopentyl-1,3,5,7-tetramethylcyclotetrasiloxane, neopentyldiethoxysilane, neohexyldiethoxysilane, neohexyltriethoxysilane, neopentyltriethoxysilane and neopentyl-di-t-butoxysilane.

Removal from CVD chamber walls of large molecules and oligomers, typically unsaturated porogen, for example alpha-terpinene ("ATRP") and ATRP oligomers, used in the CVD process is problematic for the subsequent chamber clean process, however. The processes typically used to clean CVD chambers (e.g., C₂F₆/O₂ or NF₃ plasmas) have been found ineffective for DEMS-ATRP-type porous dielectric deposition recipes. Initially, a method to volatize the ATRP residue on the CVD chamber walls using an O₂ plasma step (Step 1) followed by oxygen (e.g., O₂ or N₂O) additions to the NF₃/C₂F₆ etch process (Step 2) was attempted. Examples of these C₂F₆-based and NF₃-based chamber cleans are summarized in Table 1; Ex. 1 & 2. The purpose of the oxygen additions was to oxidize the porogen residue on the CVD chamber walls, as volatile carbon oxides (e.g., CO₂ and CO). The silicon oxides are volatized as SiF₄ by the fluorine plasma.

**Table I:**

| Process Parameters | | | | | | | | | |
|---|---|---|---|---|---|---|---|---|---|
| Ex. | Fluorine Source | Oxygen Source | Hydrogen Source | Additive Gas | Molar Ratio of Oxygen Source/ Fluorine Source | Pressure (Torr) | Remote Source? | In Situ Source? | In Situ Power (W) |
| 1 | C₂F₆ | O₂ | None | None | 2.5 | 2.5 | No | Yes | 2000 |
| 2 | NF₃ | O₂ | None | He | 2.0 | 2.0 | No | Yes | 2000 |
| 3 | NF₃ | O₂ | H₂ | He | 2.0 | 2.0 | No | Yes | 2000 |

### Example 1 C₂F₆ Prior Art Chamber Clean

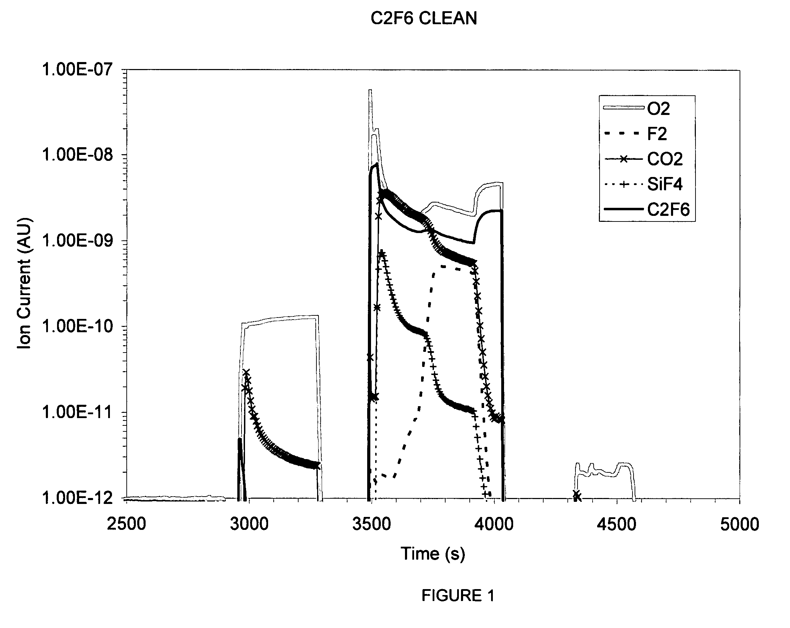

A C₂F₆ clean was run under the conditions recited above after a 2.0 µm DEMS-ATRP deposition. The QMS profile during the C₂F₆ clean that follows a 2.0 µm DEMS-ATRP deposition (Figure 1) appeared to suggest that the O₂ plasma does volatize the ATRP as CO₂, while the DEMS is volatized as SiF₄. There is a sharp increase in the CO₂ partial pressure during the O₂ plasma (Step 1, shown as 3000 s to 3300 s in Figure 1). The CO₂ pressure returns to baseline levels after about 300 s. During the subsequent C₂F₆/O₂ plasma (Step 2, shown as 3500 s to 4000 s in Figure 1), the SiF₄ partial pressures return to baseline levels after 300 s. Additionally, the rise in F₂ pressure that accompanies the decrease in SiF₄ is a good end-point monitor. Since the purpose of the O₂ plasma and C₂F₆/O₂ plasma was supposed to remove ATRP and DEMS, respectively, the QMS profile indicates the clean is complete (i.e., the clean time is sufficient). A considerable amount of brown residue remained on the chamber walls and pumping channel per column 4 of Table II.

### Example 2 Three Depositions Followed by Prior Art C₂F₆ Clean

After three 2.0 µm DEMS-ATRP depositions (i.e., 6.0 µm cumulative deposition), each followed by a C₂F₆ chamber clean at conditions recited in Table 1, the PECVD chamber was visually inspected. A considerable amount of brown residue remained on the chamber walls and pumping channel per column 4 of Table II. Since a wet clean had been performed on the PECVD chamber before investigating this chamber clean, the condition of the PECVD chamber is striking, considering only three wafers had been processed. While the QMS monitor indicated that the clean was complete, based upon traditional interpretation of the QMS, the conclusion is that the prior art C₂F₆-clean does not effectively remove all residue from the CVD chamber. A similar result was observed for the NF₃-clean (at conditions recited in Table 1).

In the present invention, a reducing chemistry is used for removing the porous dielectric film from the CVD reaction chamber walls, i.e., DEMS-ATRP residue. Although not wanting to be held to any particular theory, it is believed the present inventions use of a reducing or proton donor process step reduces and cracks the residual porogen left on the CVD chamber walls after porous dielectric deposition, generating a saturated hydrocarbon, that does not polymerize in the subsequent fluorine-based clean plasma. The proton donor or hydrogen source of the proton donor containing atmosphere may be H₂, CH₄, C₂H₆, CₓH_{y}, NH₃, or H₂O where x is 1-5 and y is 4-12, preferably fully saturating the hydrocarbon proton donor. The fluorine source of the fluorine donor containing atmosphere may be F₂, NF₃, CF₄, C₂F₆, C₃F₈, C₄F₈, C₄F₈O, CHF₃, COF₂, bisfluoroxydifluoromethane, Cₓ hydrofluorocarbons, perfluorocarbons and oxygenated fluorocarbons where x = 1-6 or other hydrofluorocarbons. The fluorine donor containing atmosphere may include a source of oxygen selected from the group consisting of oxygen, ozone, water, nitric oxide, nitrous oxide, nitrogen dioxide, silicon dioxide and mixtures thereof. The pressure may be 0.1-100 torr. The evacuation step before, between and after Step 1 and Step 2 can be less than 600 torr. The plasma conditions can be generated by RF of 500 to 10,000 Watts. The plasma can be a remote plasma decomposing the fluorine source upstream and outside the reaction chamber to be cleaned or it can be an in-situ generated plasma within the reaction chamber to be cleaned. Other energy sources, than RF, are contemplated for generating the plasma.

### Example 3 Proton Donor/Fluorine Donor Clean

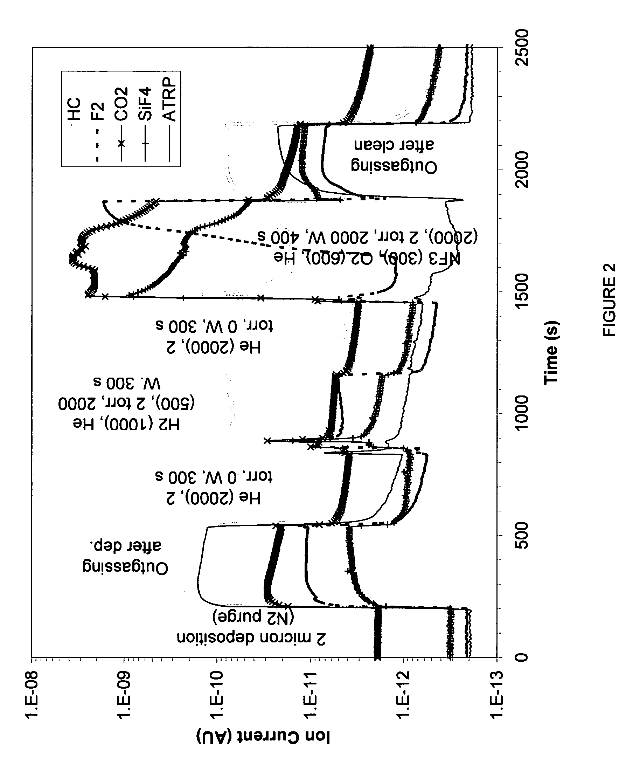

An example of the present invention used to clean a CVD chamber is given in Table 1 (Ex. 3). The porogen clean of this example is a two step process using H₂ and NF₃ at conditions recited in Table 1. The QMS profile during this Porogen-clean is shown in Figure 4. During the H₂ plasma (Step 1, shown as 800 s to 1200 s in Figure 2), ions due to hydrocarbons (HC, 15 amu) are observed indicating that the ATRP does react to form hydrocarbon etch products (NOTE: there is a background signal at 15 amu due to N₂ interference). The ATRP pressure is reduced by an order of magnitude by the H₂ plasma (i.e., less ATRP outgassing as shown in Figure 2). During the subsequent NF₃/O₂ plasma (Step 2), both SiF₄ and CO₂ etch products are observed. The pressure of these byproducts returns to baseline with the appearance of F₂, indicating the clean is complete. There was no brown residue on the chamber walls, as reported in column 4 of Table II.

### Example 4 Three Depositions Followed by Proton Donor/Fluorine Donor Clean

After three 2.0 µm DEMS-ATRP depositions (i.e., 6.0 µm cumulative deposition), each followed by the present invention porogen-clean (Table 1), the PECVD chamber was visually inspected. There was no brown residue on the chamber walls, as reported in column 4 of Table II.

**Table II:**

| Chamber Cleaning Results | | | | |
|---|---|---|---|---|
| Example (Ex.) | Number of deposition-clean cycles | Showerhead Clean? | Chamber Walls Clean? | Throttle Valve Port Clean? |
| Ex. 1 | 3 | Clean | Not clean; brown spotty residue covers all surfaces | Not clean; perimeter and port coated with brown residue |
| Ex. 2 | 3 | Clean | Not clean; brown spotty residue covers all surfaces | Not clean; perimeter and port coated with brown residue |
| Ex. 3-4 | 3 | Clean | Clean | Clean |

Feasibility experiments demonstrate that by including a reducing chemistry or proton donor (e.g., a H₂ plasma step), the PECVD chamber is more effectively cleaned following a porous ILD deposition such as the porogen-containing DEMS-ATRP deposition, i.e., carbon-containing residues as described above. The reducing chemistry of the proton donor step, such as H₂ plasma, reduces and cracks the porogen, typically large unsaturated molecules otherwise subject to fluorine-generated polymerization, generating saturated hydrocarbons, that are not polymerized in the subsequent fluorine plasma. The silicon oxide source, such as DEMS is etched as SiF₄ in the NF₃/O₂ plasma process (Step 2).

The present invention has determined that traditional fluorine donor cleans are inadequate to remove porogens from dielectric deposition chamber surfaces. Such fluorine donor cleans historically had been adequate to clean dielectric precursors and reaction products when they did not contain porogens. With the recent move to considering porogens in dielectric film depositions to achieve needed low dielectric constants, a solution to porogen and porogen reaction products and by-products has been identified in the present invention as necessary. It is particularly appropriate to reduce or crack large and unsaturated porogens on chamber walls prior to exposure to fluorine containing cleaning gases, which have the potential to polymerize the porogen at the site of unsaturation and to perfluorinate the porogen to make it relatively inert to further reaction with cleaning reagents. Hydrogen treatments have been used in semiconductor and chamber processing, but never in the presence of large molecule and/or unsaturated porogen-type molecules. Therefore, the effects of proton donor treatment of reaction chamber surfaces to clean inadvertent depositions of such molecules has not been experienced, or even recognized as aproblem in the prior art, nor has the resolution of the inadvertent deposition of such porogen molecules by proton donor or hydrogen reducing atomospheres been identified by the prior art.

The present invention has been set forth with regard to several exemplary embodiments, but the full scope of the present invention should be ascertained from the claims which follow.

## Claims

1. A process for cleaning equipment surfaces in a semiconductor material processing chamber after deposition of a porous film containing a porogen, comprising;
contacting the equipment surfaces with a proton donor containing atmosphere to react with the porogen deposited on the equipment surfaces;
contacting the equipment surfaces with a fluorine donor containing atmosphere to react with the film deposited on the equipment surfaces.

2. The process of Claim 1 wherein the contacting with the proton donor containing atmosphere is followed by contacting with the fluorine donor containing atmosphere.

3. The process of Claim 1 wherein the contacting with the fluorine donor containing atmosphere is followed by contacting with the proton donor containing atmosphere.

4. The process of Claim 1 wherein the contacting with the fluorine donor containing atmosphere is simultaneous with the contacting with the proton donor containing atmosphere.

5. The process of Claim 1 wherein the proton donor containing atmosphere comprises an agent selected from the group consisting of hydrogen, methane, ethane, ammonia, water, CₓH_{y} where x = 1-5 and y = 4-12, and mixtures thereof.

6. The process of Claim 1 wherein the proton donor atmosphere comprises a reducing atomosphere.

7. The process of Claim 1 wherein the fluorine donor containing atmosphere comprises a fluorine compound selected from the group consisting of F₂, NF₃, CF₄, C₂F₆, C₃F₈, C₄F₈, C₄F₈O, CHF₃, COF₂, bisfluoroxydifluoromethane, or other Cₓ hydrofluorocarbons and perfluorocarbons and oxygenated fluorocarbons where x = 1-6, and mixtures thereof.

8. The process of Claim 1 wherein the porogen can be at least one member selected from the group consisting of:
(a) at least one cyclic hydrocarbon having a cyclic structure and the formula CₙH₂ₙ, where n is 4 to 14, a number of carbons in the cyclic structure is between 4 and 10, and the at least one cyclic hydrocarbon optionally contains a plurality of simple or branched hydrocarbons substituted onto the cyclic structure;
(b) at least one linear or branched, saturated, partially or fully unsaturated hydrocarbon having the formula CₙH_{(2n+2)-2y} where n = 2 - 20 and where y = 0 - n;
(c) at least one singly or multiply unsaturated cyclic hydrocarbon having a cyclic structure and the formula CₙH₂ₙ₋₂ₓ, where x is a number of unsaturated sites, n is 4 to 14, a number of carbons in the cyclic structure is between 4 and 10, and the at least one singly or multiply unsaturated cyclic hydrocarbon optionally contains a plurality of simple or branched hydrocarbons substituents substituted onto the cyclic structure, and contains unsaturation inside endocyclic or on one of the hydrocarbon substituents;
(d) at least one bicyclic hydrocarbon having a bicyclic structure and the formula CₙH₂ₙ₋₂, where n is 4 to 14, a number of carbons in the bicyclic structure is from 4 to 12, and the at least one bicyclic hydrocarbon optionally contains a plurality of simple or branched hydrocarbons substituted onto the bicyclic structure;
(e) at least one multiply unsaturated bicyclic hydrocarbon having a bicyclic structure and the formula CₙH₂ₙ₋₍₂₊₂ₓ₎, where x is a number of unsaturated sites, n is 4 to 14, a number of carbons in the bicyclic structure is from 4 to 12, and the at least one multiply unsaturated bicyclic hydrocarbon optionally contains a plurality of simple or branched hydrocarbons substituents substituted onto the bicyclic structure, and contains unsaturation inside endocyclic or on one of the hydrocarbon substituents;
(f) at least one tricyclic hydrocarbon having a tricyclic structure and the formula (a) CₙH₂ₙ₋₄, where n is 4 to 14, a number of carbons in the tricyclic structure is from 4 to 12, and the at least one tricyclic hydrocarbon optionally contains a plurality of simple or branched hydrocarbons substituted onto the cyclic structure;
and mixtures thereof.

9. The process of Claim 1 wherein the porogen comprises a compound selected from the group consisting of alpha-terpinene, limonene, cyclohexane, 1,2,4-trimethylcyclohexane, 1,5-dimethyl-1,5-cyclooctadiene, camphene, adamantane, 1,3-butadiene, substituted Cₓ dienes where x = 2-18, decahydronaphthelene, and mixtures thereof.

10. The process of Claim 1 wherein the fluorine donor containing atmosphere includes a source of oxygen.

11. The process of Claim 1 wherein the fluorine donor containing atmosphere includes a source of oxygen selected from the group consisting of oxygen, ozone, water, nitric oxide, nitrous oxide, nitrogen dioxide, silicon dioxide and mixtures thereof.

12. The process of Claim 1 wherein a precursor for the film and the porogen are contained in the same molecule.

13. The method of claim 1 wherein the porous film is selected from the group consisting of diethoxymethylsilane, dimethoxymethylsilane, di-isopropoxymethylsilane, di-t-butoxymethylsilane, methyltriethoxysilane, methyltrimethoxysilane, methyltriisopropoxysilane, methyltri-t-butoxysilane, dimethyldimethoxysilane, dimethyldiethoxysilane, dimethyldi-isopropoxysilane, dimethyldi-t-butoxysilane, 1,3,5,7-tetramethylcyclotatrasiloxane, octamethyl-cyclotetrasiloxane, tetraethoxysilane, and mixtures thereof.

14. The process of Claim 1 wherein the porous film comprises an organosilicon glass with the composition represented by the formula SiᵥO_{w}CₓH_{y}F_{z}, where v+w+x+y+z = 100%, v is from 5 to 35 atomic%, w is from 10 to 65 atomic%, x is from 5 to 70 atomic%, y is from 10 to 70 atomic%, and z is from 0 to 15 atomic%.

15. A process for cleaning equipment surfaces in a semiconductor material CVD processing chamber after deposition of a porous dielectric film containing a porogen, comprising;
evacuating a zone contacting the equipment surface;
maintaining the zone under plasma conditions;
contacting the equipment surfaces with a proton donor containing atmosphere to react with the porogen deposited on the equipment surfaces;
evacuating the zone contacting the equipment surface;
contacting the equipment surfaces with a fluorine donor and oxygen source containing atmosphere to react with the dielectric film deposited on the equipment surfaces to clean the equipment surfaces.

16. The process of Claim 15 wherein the proton donor containing atmosphere includes an inert gas.

17. The process of Claim 15 wherein the fluorine donor containing atmosphere includes an inert gas.

18. The process of Claim 15 wherein plasma is generated by radio frequency of 500 to 5000 Watts.

19. The process of Claim 15 wherein the evacuating is conducted to a pressure no greater than 600 torr.

20. A process for cleaning equipment surfaces in a semiconductor material CVD processing chamber after deposition of a porous dielectric film from diethoxymethylsilane containing an alph-terpinene porogen, comprising;
(a) evacuating a zone contacting the equipment surface to a pressure no greater than 600 torr;
(b) maintaining the zone under plasma conditions generated by radio frequency of 1000 to 2000 Watts;
(c) contacting the equipment surfaces with hydrogen to react with the alph-terpinene porogen deposited on the equipment surfaces; then,
(d) evacuating the zone contacting the equipment surface to a pressure no greater than 600 torr; and then,
(e) contacting the equipment surfaces with NF₃ and O₂ to react with the dielectric film deposited on the equipment surfaces to clean the equipment surfaces.

21. A process for cleaning equipment surfaces in a semiconductor material CVD processing chamber after deposition of a porous dielectric film from diethoxymethylsilane containing an alph-terpinene porogen, comprising;
(a) evacuating a zone contacting the equipment surface to a pressure no greater than 600 torr;
(b) maintaining the zone under plasma conditions generated by radio frequency of 1000 to 2000 Watts;
(c) contacting the equipment surfaces with hydrogen to react with the alph-terpinene porogen deposited on the equipment surfaces; then,
(d) evacuating the zone contacting the equipment surface to a pressure no greater than 600 torr; and then,
(e) contacting the equipment surfaces with C₂F₆ and O₂ to react with the dielectric film deposited on the equipment surfaces to clean the equipment surfaces.
